# FASCICULE DE BREVET EUROPEEN

(11) **EP 2 855 744 B1**
(45) Date de publication et mention de la délivrance du brevet: **25.05.2016**
(21) Numéro de dépôt: 13739796.4
(22) Date de dépôt: 03.06.2013
(51) Int. Cl.: B82Y 10/00, B82Y 40/00, C23F 1/00, H01B 1/02, H01B 13/00, H01L 29/06, H01L 29/41, C30B 29/60, C30B 29/62, C30B 33/10

(54) **PROCÉDÉ D'AMÉLIORATION DES PERFORMANCES ÉLECTRIQUES ET OPTIQUES D'UN MATÉRIAU CONDUCTEUR ÉLECTRIQUE ET TRANSPARENT A BASE DE NANOFILS D'ARGENT**
VERFAHREN ZUR VERBESSERUNG DER ELEKTRISCHEN UND OPTISCHEN LEISTUNG EINES TRANSPARENTEN ELEKTRISCH LEITENDEN MATERIALS AUF DER BASIS VON SILBERNANODRÄHTEN
PROCESS FOR IMPROVING THE ELECTRICAL AND OPTICAL PERFORMANCE OF A TRANSPARENT ELECTRICALLY CONDUCTIVE MATERIAL BASED ON SILVER NANOWIRES

(30) Priorité: 05.06.2012 FR 1255226
(43) Date de publication de la demande: 08.04.2015
(73) Titulaire: Commissariat à l'Énergie Atomique et aux Énergies Alternatives, 75015 Paris (FR)
(72) Inventeur: SIMONATO, Jean-Pierre, F-38360 Sassenage (FR); CARELLA, Alexandre, F-64110 Mazeres Lezons (FR); CELLE, Caroline, F-42700 Firminy (FR)
(74) Mandataire: Gevers & Orès
(86) Numéro de dépôt international: PCT/IB2013/054562
(87) Numéro de publication internationale: WO 2013/182969

(56) Documents cités:
- CAI-HONG LIU ET AL: "Silver nanowire-based transparent, flexible, and conductive thin film", NANO SCALE RESEARCH LETTERS SPRINGER-VERLAG USA, vol. 6, no. 1, 2011, XP002688287, ISSN: 1931-7573

## Description

L'invention concerne un procédé d'amélioration des performances électriques et optiques d'un matériau conducteur électrique et transparent comprenant des nanofils d'argent.

Elle concerne également un procédé de fabrication d'une couche en un matériau conducteur électrique et transparent, telle qu'une électrode transparente ou un film chauffant transparent.

Les matériaux possédant une combinaison optimale de haute conductivité électrique, de transparence optique et de flexibilité sont des composants extrêmement importants dans le développement de nombreux domaines à forte valeur ajoutée, et notamment tout ce qui touche à l'électronique « grande surface », c'est-à-dire celle réalisée par des techniques d'impression et à basse température.

Les électrodes transparentes usuellement utilisées sont fabriquées à partir d'oxydes métalliques (oxyde d'indium et d'étain, oxyde d'étain dopé au fluor...) et ne sont pas flexibles. Elles perdent leurs performances de conduction lorsqu'elles sont soumises à des flexions avec des rayons de courbures petits (par exemple inférieurs à 8 mm, et notamment de façon répétée).

Les récentes avancées dans le domaine des nanotechnologies permettent d'entrevoir aujourd'hui des alternatives crédibles à la réalisation de films fins transparents chauffants. En effet, un certain nombre d'électrodes transparentes à base de nanotubes de carbone, de graphène, de polymères (de type PEDOT:PSS) ou de nanofils métalliques (métal = argent essentiellement) a été rapporté. Ces électrodes transparentes peuvent être réalisées sur des films plastiques transparents et donc être identifiées comme des électrodes transparentes flexibles.

L'utilisation de nanofils métalliques permet de d'obtenir les meilleures performances à ce jour. Le système conducteur et transparent est obtenu en fabriquant un réseau percolant de nanofils métalliques sur une surface. Ces réseaux sont obtenus par dépôt d'une suspension de nanofils dans un solvant (eau, méthanol, isopropanol...). Les réseaux de nanofils d'argent présentent une résistance carrée faible à 90% de transmittance (mesure réalisée à 550nm), typiquement inférieure à 60 ohm/carré. (Yu, Zhang et al. 2011, "Highly Flexible Silver Nanowire Electrodes for Shape-Memory Polymer Light-Emitting Diodes" Advanced Materials 23(5): 664-668.)

Par exemple, pour une application en dispositif optoélectronique, une baisse de résistance électrique implique un meilleur passage du courant. A titre d'exemple, ceci peut se traduire par une amélioration des performances (rendement) pour des cellules photovoltaïques ou des écrans émissifs à base d'OLED (*organic light emitting diode)* ou de PLED (*polymer light emitting diode*) (meilleure efficacité lumineuse).

Dans un autre exemple, celui des films chauffants transparents souples, la baisse de résistance permet d'améliorer les performances de chauffage, car la puissance thermique dissipée par le film chauffant est proportionnelle à V²/R (effet Joule). Ici V est la tension appliquée aux bornes du film chauffant (en courant continu DC) et R est la résistance du dispositif d'une borne à l'autre.

Il est souhaitable d'améliorer encore ces performances existantes.

A cet effet, l'invention propose un procédé d'amélioration des performances électriques et optiques d'un matériau électrique et transparent comprenant des nanofils d'argent, caractérisé en ce qu'il comprend :
a) une étape de mise en contact des nanofils d'argent avec une solution d'un acide, cette solution ayant un pH inférieur à 7, de préférence inférieur à 3, et
b) une étape d'élimination de l'acide.

Dans une première variante, les étapes a) et b) sont mises en oeuvre sur les nanofils d'argent avant la fabrication du matériau électrique et transparent.

Dans une seconde variante, les étapes a) et b) sont mises en oeuvre une fois le matériau électrique et transparent fabriqué.

Dans toutes les variantes, à l'étape a) la solution d'acide est de préférence une solution aqueuse d'acide nitrique, ou d'acide sulfurique, ou d'acide acétique, ou d'acide formique, ou d'acide phosphorique, ou d'acide trifluoroacétique, plus préférablement d'acide nitrique, solution d'acide ayant de préférence, une teneur en acide supérieure ou égale à 0,2% et inférieure ou égale à 20%, en masse d'acide par rapport à la masse totale de la solution.

De préférence également, à l'étape a) la mise en contact est effectuée pendant une durée comprise entre 2 à 10 min, de préférence de 3 à 7 min, à température ambiante.

L'invention propose également un procédé de fabrication d'une couche en un matériau conducteur électrique et transparent à base de nanofils d'argent qui comprend une étape de mise en oeuvre du procédé d'amélioration des performances électriques et optiques d'un matériau électrique et transparent selon l'invention.

Elle propose aussi un procédé de fabrication d'une électrode transparente et conductrice, qui comprend une étape de mise en oeuvre du procédé d'amélioration des performances électriques et optiques d'un matériau électrique et transparent selon l'invention.

Elle propose encore un procédé de fabrication d'un film chauffant transparent qui comprend une étape de mise en oeuvre du procédé d'amélioration des propriétés électriques et optiques d'un matériau électrique et transparent selon l'invention.

Elle propose enfin un procédé de fabrication d'un film conducteur qui permette le blindage électromagnétique.

L'invention sera mieux comprise et d'autres caractéristiques et avantages de celle-ci apparaîtront plus clairement à la lecture de la description explicative qui suit.

L'invention propose un procédé d'amélioration des performances électriques et optiques d'un matériau conducteur électrique et transparent à base de nanofils d'argent.

Ces matériaux conducteurs électriques et transparents à base de nanofils d'argent sont connus.

Ils sont fabriqués par différents procédés tels que des techniques d'impression à partir de solutions de nanofils, comme la nébulisation, le dépôt à la tournette, l'enduction, la sérigraphie, etc... des différents composants de la couche (dont des nanofils d'argent) sur un substrat qui peut être rigide ou souple, voire étirable (moins de 20% d'extension) dont la surface peut être plane ou structurée (présence de motifs ou de rugosités importantes).

La couche obtenue peut être utilisée comme électrode transparente, essentiellement pour des dispositifs d'optoélectronique, ou comme couche chauffante par application d'une tension aux bornes de la couche, ou encore comme film conducteur permettant le blindage.

Cependant, il est souhaitable d'obtenir à la fois une haute transmittance et une faible résistance électrique de telles couches.

Dans une telle couche, on obtient un réseau percolant de nanofils d'argent qui a une transmittance supérieure à 50%, lorsque mesurée à 550 nm par spectrométrie UV-vis-PIR, en utilisant comme référence le substrat utilisé, qui est en général du verre ou du polyéthylènenaphtalate (PEN), et une résistance carrée inférieure à 200 ohm/carré (mesurée par un résistivimètre 4 pointes de type Loresta EP).

Le spectrophotomètre utilisé est un spectrophotomètre Varian Cary 5000.

Afin d'améliorer encore la transmittance et diminuer la résistance électrique de telles couches, l'invention propose de traiter les nanofils d'argent, avant ou après la mise en oeuvre du procédé proprement dit de fabrication de la couche de matériau électrique transparent, avec une solution d'acide.

Il est particulièrement surprenant qu'un tel traitement à l'acide permette d'améliorer les performances électriques et optiques d'un matériau électrique et transparent comprenant des nanofils d'argent car il est extrêmement bien connu de l'homme de l'art que les acides, en particulier l'acide nitrique, sont d'excellents agents de solubilisation de l'argent.

Le nitrate d'argent, par exemple, est classiquement obtenu par dissolution d'agents métalliques dans une solution d'acide nitrique.

D'ailleurs, les inventeurs ont notamment constaté le fait qu'en laissant une électrode comprenant des nanofils d'argent dans de l'acide nitrique à 65% pendant 15 min, la totalité de l'électrode était dissoute et que l'argent dissous peut être retrouvé en solution comme cela est montré par un dosage, par exemple par la technique d'ICP-OES (Spectrométrie par plasma à couplage induit) avec un Spectromètre Agilent séries 700.

Ainsi, l'homme du métier était *a priori* écarté de l'idée d'effectuer un traitement avec un acide, en particulier l'acide nitrique, sur des nanofils d'argent, ces nanofils étant extrêmement fins (les nanofils d'argent sont des objets dont au moins une des dimensions est inférieure ou égale à 1 µm), car *a priori* ce traitement aurait dû détruire ou au moins endommager très fortement ces nanofils d'argent et donc détériorer les propriétés de la couche de matériau électrique et transparente fabriquée ou a fabriquer.

Or, les inventeurs ont constaté que, de façon surprenante, la mise en contact des nanofls d'argent lorsqu'ils sont en dispersion dans un solvant tel que l'eau ou un alcool, avec une solution d'acide nitrique, sulfurique, acétique, formique, phosphorique ou trifluoroacétique notamment et plus particulièrement d'acide nitrique dont le pH est inférieur à 7, et plus préférablement inférieur à 3, les nanofïls d'argent ne sont pas dissous et que les électrodes réalisées avec des nanofils ayant subi ce traitement acide ont de meilleures performances par rapport aux électrodes obtenues avec des nanofils n'ayant pas été mis en contact avec l'acide. Le pH est de préférence supérieur à 0,1.

Mais plus encore, les inventeurs ont noté que même lorsque la mise en contact avec la solution d'acide telle que définie ci-dessus était effectuée avec les nanofils d'argent déjà dans un matériau électrique et transparent, les performances de cette couche, en tant qu'électrode ou en tant que film chauffant souple étaient également nettement améliorées.

La solution d'acide peut être une solution aqueuse, alcoolique ou hydroalcoolique ou encore dans tout solvant qui apparaîtra à l'homme de l'art. De préférence, la solution d'acide sera une solution aqueuse.

Bien que les performances du matériau électrique et transparent comprenant les nanofils d'argent ainsi traités ou du matériau électrique et transparent comprenant des nanofils, lui-même traité dans sa totalité par une mise en contact dans la solution, les meilleurs résultats en termes d'amélioration de performances sont obtenus en utilisant de l'acide nitrique.

La teneur maximale en acide dans la solution d'acide est de 20% en masse, par rapport au poids total de la solution.

Avec une teneur plus élevée en acide, les performances électriques et optiques du matériau électrique et transparent comprenant les nanofils d'argent sont détériorées.

La teneur minimale en acide est de 0,2% en masse d'acide, par rapport au poids total de la solution d'acide. En dessous, le traitement est très long.

La durée de la mise en contact est comprise entre 2 et 10 min. De préférence, elle est comprise entre 2 et 7 min. Le plus préférablement, elle est de 5 min.

Le traitement (mise en contact) avec l'acide est effectué à température ambiante, c'est-à-dire à une température comprise entre 17 et 27°C.

La couche de matériau électrique et transparent comprenant des nanofils d'argent, une fois formée, est une couche d'un matériau électrique et transparent dans laquelle les nanofils d'argent forment un réseau percolant.

Ces réseaux de nanofils peuvent être ultérieurement chauffés jusqu'à 200°C, compressés, éventuellement à chaud, ou soumis à des tensions élevées afin d'améliorer encore les performances du matériau électrique et transparent ainsi obtenu.

Bien entendu, après la mise en contact avec la solution acide, les nanofils d'argent, ou le matériau électrique et transparent comprenant les nanofils d'argent, sont lavés avec l'eau.

Cela peut être effectué par des traitements successifs de lavage/centrifugation pour éliminer tout l'acide résiduel.

Lorsque le traitement est effectué sur les nanofils d'argent avant la fabrication du matériau électrique et transparent, les nanofils sont alors déposés ensuite pour fabriquer le matériau électrique et transparent, en particulier une électrode transparente ou un film chauffant.

Alternativement, les nanofils d'argent peuvent être d'abord déposés sur le support du matériau électrique et transparent qui lui-même est entièrement plongé dans la solution d'acide et ensuite lavé.

Lorsque le matériau électrique et transparent est une électrode, une encapsulation de l'électrode peut être réalisée après le séchage de cette électrode. L'encapsulation peut, à titre d'exemple, être réalisée par un des moyens mentionnés dans le document NanoMarkets, LC (NanoMarkets, LC | PO Box 3840 | Glen Allen, VA 23058 ), intitulé « Encapsulation and Flexible Substrates For Organic and Dye-Sensitized Photovoltaics" - Nano-306 - Published January 2011.

Afin de mieux faire comprendre l'invention, on va en décrire ci-après, plusieurs exemples de mise en oeuvre, à titre d'exemples purement illustratifs et non limitatifs.

### Exemple comparatif 1.

Des nanofils d'argent sont fabriqués selon le procédé suivant :
1,766 g de PVP (polyvinylpyrrolidone) sont additionnés à 2,6 mg de NaCl (chlorure de sodium) dans 40 ml d'EG (éthylèneglycol), le mélange est agité à 600 rpm à 120°C jusqu'à complète dissolution du PVP + NaCl (environ 4-5 minutes).

A l'aide d'une ampoule de coulée, on ajoute goutte à goutte ce mélange à une solution de 40 ml d'EG dans laquelle sont dissous 0,68 g de AgNO₃ (nitrate d'argent).

On chauffe le bain d'huile à 160°C et on laisse agiter à 700 rpm pendant 80 minutes.

Trois lavages sont réalisés au méthanol en centrifugeant à 2000 rpm (tours par minute) pendant 20 min, puis les nanofils sont précipités à l'acétone et enfin redispersés dans de l'eau ou du méthanol.

Des électrodes sont réalisées sur du verre Eagle XG (*Corning*) par vaporisation de la solution ainsi obtenue en utilisant un aérographe Aztek A4709 ou par dépôt à la tournette.

Les substrats ainsi formés ont une résistance carrée de 38 ohm/carré à 87 % de transmittance (à 550 nm).

### Exemple 1.

Des nanofils d'argent sont fabriqués selon le procédé suivant ;
1,766 g de PVP (polyvinylpyrrolidone) sont additionnés à 2,6 mg de NaCl (chlorure de sodium) dans 40 ml d'EG (éthylèneglycol), le mélange est agité à 600 rpm à 120°C jusqu'à complète dissolution du PVP + NaCl (environ 4-5 minutes).

A l'aide d'une ampoule de coulée, on ajoute goutte à goutte ce mélange à une solution de 40 ml d'EG dans laquelle sont dissous 0,68 g de AgNO₃ (nitrate d'argent).

On chauffe le bain d'huile à 160°C et on laisse agiter à 700 rpm pendant 80 min.

Trois lavages sont réalisés au méthanol en centrifugeant à 2000 rpm pendant 20 min, puis les nanofils sont précipités à l'acétone et enfin redispersés dans du méthanol.

Dans un tube contenant 10 mL de méthanol contenant des nanofils d'argent, sont rajoutés 20 mL de solution aqueuse d'acide nitrique à une teneur de 5% massique par rapport à la masse totale de la solution aqueuse. Après agitation manuelle pendant 5 minutes, les tubes sont centrifugés à 5000 rpm. La phase liquide est éliminée. Les nanofils sont remis en suspension dans de l'eau, lavés et redispersés dans du méthanol. Ce traitement avec un acide, suivi de lavages, est effectué à la température ambiante.

Des électrodes sont réalisées sur du verre Eagle XG (*Corning*) par vaporisation de la solution obtenue en utilisant un aérographe Aztek A4709 ou par dépôt à la tournette.

Les substrats ainsi formés ont une résistance carrée de 18 ohm/carré à 88 % de transmittance (à 550 nm).

On voit à partir de cet exemple 1 et de l'exemple comparatif 1 qu'un traitement avec de l'acide nitrique, même pendant seulement 5 min, est suffisant pour améliorer les performances des électrodes obtenues.

### Exemple 2.

Des nanofils d'argent sont fabriqués selon le procédé suivant :
1,766 g de PVP (polyvinylpyrrolidone) sont additionnés à 2,6 mg de NaCl (chlorure de sodium) dans 40 ml d'EG (éthylèneglycol) le mélange est agité à 600 rpm à 120°C jusqu'à complète dissolution du PVP + NaCl (environ 4-5 minutes).

A l'aide d'une ampoule de coulée, on ajoute goutte à goutte ce mélange à une solution de 40 ml d'EG dans laquelle sont dissous 0,68 g de AgNO₃ (nitrate d'argent).

On chauffe le bain d'huile à 160°C et on laisse agiter à 700 rpm pendant 80 min.

Trois lavages sont réalisés au méthanol en centrifugeant à 2000 rpm pendant 20 min, puis les nanofils sont précipités à l'acétone et enfin redispersés dans de l'eau.

A une solution aqueuse de 10 mL contenant des nanofils d'argent, sont rajoutés 20 mL de solution aqueuse d'acide sulfurique à une teneur de 5% massique. Après agitation manuelle pendant 5 min, les tubes sont centrifugés à 5000 rpm.

La phase liquide est éliminée.

Les nanofils sont remis en suspension dans de l'eau, lavés et redispersés dans du méthanol.

Des électrodes sont réalisées sur du verre Eagle XG (*Corning*) par vaporisation de la solution en utilisant un aérographe Aztek A4709 ou par dépôt à la tournette.

Les substrats ainsi formés ont une résistance carrée de 27 ohm/carré à 88 % de transmittance (à 550 nm).

On voit à partir des exemples 1 et 2 et de l'exemple comparatif 1 que les performances des électrodes sont améliorées par un traitement des nanofils d'argent à l'acide nitrique aussi bien que par un traitement à l'acide sulfurique mais qu'un traitement à l'acide nitrique est préférable.

### Exemple comparatif 2.

Des nanofils d'argent sont fabriqués selon le procédé suivant :
1,766 g de PVP (polyvinylpyrrolidone) sont additionnés à 2,6 mg de NaCl (chlorure de sodium) dans 40 ml d'EG (éthylèneglycol) le mélange est agité à 600 rpm à 120°C jusqu'à complète dissolution du PVP + NaCl (environ 4-5 minutes).

A l'aide d'une ampoule de coulée, on ajoute goutte à goutte ce mélange à une solution de 40 ml d'EG dans laquelle sont dissous 0,68 g de AgNO₃ (nitrate d'argent).

On chauffe le bain d'huile à 160°C et on laisse agiter à 700 rpm pendant 80 min.

Trois lavages sont réalisés au méthanol en centrifugeant à 2000 rpm pendant 20 min, puis les nanofils sont précipités à l'acétone et enfin redispersés dans du méthanol.

Des électrodes sont réalisées sur du polyéthylènenaphtalate (PEN) de 125 µm d'épaisseur par vaporisation de la solution obtenue en utilisant un aérographe Aztek A4709.

Les électrodes ainsi fabriquées ont une résistance carrée de 28 ohm/carré à 83 % de transmittance (à 550 nm).

### Exemple 3.

Les électrodes décrites à l'exemple comparatif sont immergées 15 minutes dans une solution contenant 5% massique d'acide nitrique, puis rincées à l'eau et séchées.

La résistance carrée mesurée est alors de 13 ohm/carré à 84 % de transmittance (à 550 nm).

Ces performances sont conservées au moins pendant plusieurs mois.

### Exemple 4.

Les électrodes décrites à l'exemple comparatif sont immergées 15 minutes dans une solution contenant 5% massique d'acide sulfurique, puis rincées à l'eau et séchées.

La résistance carrée mesurée est alors de 21 ohm/carré à 83 % de transmittance (à 550 nm).

### Exemple 5.

Les électrodes décrites à l'exemple comparatif sont immergées 15 minutes dans une solution contenant 5% massique d'acide acétique, puis rincées à l'eau et séchées.

Les performances mesurées sont alors : une résistance carrée 26 ohm/carré à 83 % de transmittance (à 550 nm).

Les électrodes ou couches de matériaux électriques ou optiques selon l'invention, peuvent être utilisées, par exemple, dans des cellules photovoltaïques, des écrans tactiles, des écrans émissifs (OLEDs, PLEDs, LCD, thermochromiques), des photodétecteurs, des films chauffants, des transistors organiques, des films pour du blindage électromagnétique.

## Revendications

1. Procédé d'amélioration des performances électriques et optiques d'un matériau conducteur électrique et transparent comprenant des nanofils d'argent, **caractérisé en ce qu'**il comprend :
a) une étape de mise en contact des nanofils d'argent avec une solution d'un acide, cette solution ayant un pH inférieur à 7, de préférence inférieur à 3, et
b) une étape d'élimination de l'acide.

2. Procédé selon la revendication 1, **caractérisé en ce que** les étapes a) et b) sont misses en oeuvre sur les nanofils d'argent avant la fabrication du matériau électrique et transparent.

3. Procédé selon la revendication 1, **caractérisé en ce que** les étapes a) et b) sont mises en oeuvre une fois le matériau électrique et transparent fabriqué.

4. Procédé selon l'une quelconque des revendications précédentes, **caractérisé en ce qu'**à l'étape a) la solution d'acide est une solution aqueuse d'acide nitrique, ou d'acide sulfurique, ou d'acide acétique, ou d'acide formique, ou d'acide phosphorique, ou d'acide trifluoroacétique, de préférence d'acide nitrique, solution d'acide ayant de préférence, une teneur en acide supérieure ou égale à 0,2% et inférieure ou égale à 20%, en masse d'acide par rapport à la masse totale de la solution.

5. Procédé selon l'une quelconque des revendications précédentes, **caractérisé en ce qu'**à l'étape a) la solution est une solution d'acide nitrique et **en ce que** la mise en contact est effectuée pendant une durée comprise entre 2 et 10 min, de préférence de 3 à 7 min, à température ambiante.

6. Procédé de fabrication d'une couche en un matériau conducteur électrique et transparent à base de nanofils d'argent, **caractérisé en ce qu'**il comprend une étape de mise en oeuvre du procédé d'amélioration des performances électriques et optiques d'un matériau conducteur électrique et transparent selon l'une quelconque des revendications 1 à 5.

7. Procédé de fabrication d'une électrode transparente et conductrice, **caractérisé en ce qu'**il comprend une étape de mise en oeuvre du procédé d'amélioration des performances électriques et optiques d'un matériau conducteur électrique et transparent selon l'une quelconque des revendications 1 à 5.

8. Procédé de fabrication d'un film chauffant transparent **caractérisé en ce qu'**il comprend une étape de mise en oeuvre du procédé d'amélioration des propriétés électriques et optiques d'un matériau conducteur électrique et transparent selon l'une quelconque des revendications 1 à 5.

9. Procédé de fabrication d'un film pour blindage électromagnétique, **caractérisé en ce qu'**il comprend une étape de mise en oeuvre du procédé d'amélioration des propriétés électriques et optiques d'un matériau conducteur électrique et transparent selon l'une quelconque des revendications 1 à 5.

## Patentansprüche

1. Verfahren zur Verbesserung der elektrischen und optischen Leistungen eines elektrisch leitenden und transparenten Materials, das Silbernanodrähte umfasst, **dadurch gekennzeichnet, dass** es umfasst:
a) einen Schritt des Inkontaktversetzens der Silbernanodrähte mit einer Lösung einer Säure, wobei die Lösung einen pH unter 7, vorzugsweise unter 3, aufweist und
b) einen Säureentfernungsschritt.

2. Verfahren nach Anspruch 1, **dadurch gekennzeichnet, dass** die Schritte a) und b) auf den Silber-Nanodrähten vor der Herstellung des elektrisch leitenden und transparenten Material umgesetzt werden.

3. Verfahren nach Anspruch 1, **dadurch gekennzeichnet, dass** die Schritte a) und b) umgesetzt werden, sobald das elektrisch leitende und transparente Material hergestellt ist.

4. Verfahren nach einem der vorhergehenden Ansprüche, **dadurch gekennzeichnet, dass** in Schritt a) die Säurelösung eine wässrige Salpetersäure- oder Schwefelsäure- oder Essigsäure- oder Ameisensäure- oder Phosphorsäure- oder Trifluoressigsäurelösung, vorzugsweise Salpetersäurelösung, ist, wobei die Säurelösung vorzugsweise einen Säuregehalt hat, der über oder gleich 0,2 Ma% und unter oder gleich 20 Ma% Säure, bezogen auf das Gesamtgewicht der Lösung, beträgt.

5. Verfahren nach einem der vorhergehenden Ansprüche, **dadurch gekennzeichnet, dass** in Schritt a) die Lösung eine Salpetersäurelösung ist und dass das Inkontaktversetzen während einer Dauer zwischen 2 und 10 Minuten inklusive, vorzugsweise von 3 bis 7 Minuten, bei Raumtemperatur durchgeführt wird.

6. Verfahren zur Herstellung einer Schicht aus einem elektrisch leitenden und transparenten Material auf der Basis von Silber-Nanodrähten, **dadurch gekennzeichnet, dass** es einen Umsetzungsschritt des Verfahrens zur Verbesserung der elektrischen und optischen Leistungen eines elektrisch leitenden und transparenten Materials nach einem der Ansprüche 1 bis 5 umfasst.

7. Verfahren zur Herstellung einer transparenten und leitenden Elektrode, **dadurch gekennzeichnet, dass** es einen Umsetzungsschritt des Verfahrens zur Verbesserung der elektrischen und optischen Leistungen eines elektrisch leitenden und transparenten Materials nach einem der Ansprüche 1 bis 5 umfasst.

8. Verfahren zur Herstellung einer transparenten Heizfolie, **dadurch gekennzeichnet, dass** es eine Umsetzungsschritt des Verfahrens zur Verbesserung der elektrischen und optischen Leistungen eines elektrisch leitenden und transparenten Materials nach einem der Ansprüche 1 bis 5 umfasst.

9. Verfahren zur Herstellung einer Folie zur elektromagnetischen Abschirmung, **dadurch gekennzeichnet, dass** es einen Umsetzungsschritt des Verfahrens zur Verbesserung der elektrischen und optischen Leistungen eines elektrisch leitenden und transparenten Materials nach einem der Ansprüche 1 bis 5 umfasst.

## Claims

1. A method for improving electrical and optical performances of a transparent electrically conductive material comprising silver nanowires, **characterized in that** it comprises:
a) a step of contacting the silver nanowires with a solution of an acid, this solution having a pH of less than 7, preferably less than 3, and
b) a step of removing the acid.

2. The method according to claim 1, **characterized in that** steps a) and b) are carried out on silver nanowires before manufacturing the electrical and transparent material.

3. The method according to claim 1, **characterized in that** steps a) and b) are carried out once the electrical and transparent material is manufactured.

4. The method according to any of the preceding claims, **characterized in that** in step a) the acid solution is an aqueous solution of nitric acid, or of sulfuric acid, or of acetic acid, or of formic acid, or of phosphoric acid, or of trifluoroacetic acid, preferably of nitric acid, and acid solution preferably having an acid content greater than or equal to 0.2% and less than or equal to 20%, by weight of acid based on the total weight of the solution.

5. The method according to any of the preceding claims, **characterized in that** in step a) the solution is a nitric acid solution and **in that** the contacting is carried out for a period comprised between 2 and 10 mins, preferably from 3 to 7 mins, at room temperature.

6. A method for manufacturing a layer made of an electrical and transparent conductive material based on silver nanowires, **characterized in that** it comprises a step of carrying out the method for improving the electrical and optical performances of an electrical and transparent conductive material according to any of claims 1 to 5.

7. A method for manufacturing a transparent and conductive electrode, **characterized in that** it comprises a step of carrying out the method for improving the electrical and optical performances of an electrical and transparent conductive material according to any of claims 1 to 5.

8. A method for manufacturing a transparent heating film, **characterized in that** it comprises a step of carrying out the method for improving the electrical and optical performances of an electrical and transparent conductive material according to any of claims 1 to 5.

9. A method for manufacturing a film for electromagnetic shielding, **characterized in that** it comprises a step of carrying out the method for improving electrical and optical properties of an electrical and transparent conductive material according to any of claims 1 to 5.
